# EUROPÄISCHE PATENTANMELDUNG

(11) **EP 1 930 735 A1**
(43) Veröffentlichungstag der Anmeldung: **11.06.2008**
(21) Anmeldenummer: 06025380.4
(22) Anmeldetag: 08.12.2006
(51) Int. Cl.: G01R 15/18

(54) **Vorrichtung und Verfahren zum Messen von Wechselströmen**

(71) Anmelder: HÜTTINGER Elektronik GmbH + Co. KG, 79111 Freiburg (DE)
(72) Erfinder: Kirchmeier, Thomas, 79331 Teningen (DE)
(74) Vertreter: Kohler Schmid Möbus

(57) **Zusammenfassung**

Eine Vorrichtung zum Messen von Wechselströmen (I_{HF}) weist auf: eine erste Kopplungseinrichtung (2) mit einer ersten Primärspule (3) und einer ersten Sekundärspule (4), wobei die erste Primärspule und die erste Sekundärspule induktiv gekoppelt sind, und eine zweite Kopplungseinrichtung (6) mit einer zweiten Primärspule (7) und einer zweiten Sekundärspule (8), wobei die zweite Primärspule und die zweite Sekundärspule induktiv gekoppelt sind. Die erste und zweite Kopplungseinrichtung (2, 6) sind elektrisch miteinander verbunden, und ein Übersetzungsverhältnis der Vorrichtung ist aus dem Produkt der Übersetzungsverhältnisse der ersten und zweiten Kopplungseinrichtungen gebildet.

## Beschreibung

Die Erfindung betrifft eine Vorrichtung und ein Verfahren zum Messen von Wechselströmen.

Zum Messen von Wechselströmen werden im Allgemeinen so genannte Stromwandler oder Strommesswandler verwendet, bei denen es sich um speziell ausgebildete Transformatoren handelt. Zum Messen insbesondere großer Wechselströme wird dabei der zu messende Strom proportional um das Verhältnis von Primär- zu Sekundärwindungen des Transformators verringert und kann dann als potentialgetrenntes Abbild des Primärstroms mit verfügbaren Messinstrumenten oder elektrischen Schaltungen (Auswerteschaltungen) weiter verarbeitet werden.

Bei einem Wechselstrommesswandler handelt es sich also um einen sekundärseitig praktisch oder im Wesentlichen kurzgeschlossenen Transformator zur Bestimmung des Primärstroms aus der Messung des Sekundärstroms.

Zur Messung von Wechselströmen im Grenzbereich unterhalb 1 MHz sind Ringkern-Stromwandler mit einem Übersetzungsverhältnis (Primär- zu Sekundärwindungszahl) von 1:10 bis 1:100 hinreichend bekannt und bieten eine kostengünstige und effiziente Lösung zur potentialfreien Messung von großen Wechselströmen.

Im Bereich oberhalb von 1 MHz schränken jedoch zwei Phänomene die Einsatzmöglichkeiten derartiger vorbekannter Wechselstrommesswandler stark ein: Zum einen ergeben sich durch Kapazitäten von Windung gegen Windung und der Wicklung gegenüber dem Kern hochfrequente Resonanzen, die das Messsignal unbrauchbar machen. Darüber hinaus wird durch die Kapazität von Primärleitung gegenüber der Sekundärwicklung ein so genanntes Common Mode-Spannungssignal überlagert, welches das differenzielle, der Messung dienende Stromsignal um ein Vielfaches übersteigen kann, wenn ein zu messender Leiter ein beträchtliches Maß an hochfrequenter Spannung führt.

Zur Vermeidung dieser Probleme ist aus dem Stand der Technik bekannt, aufwändige und kostenintensive, jedoch meist nur bedingt wirksame Abschirm- und Signalentstörungsmaßnahmen vorzunehmen.

Es ist die Aufgabe der vorliegenden Erfindung, eine Vorrichtung und ein Verfahren zum Messen von Wechselströmen anzugeben, die ohne aufwändige Abschirm- und Signalentstörungsmaßnahmen auskommen.

Die Aufgabe wird gelöst durch eine Vorrichtung zum Messen von Wechselströmen, aufweisend: eine erste Kopplungseinrichtung mit einer ersten Primärspule und einer ersten Sekundärspule, wobei die erste Primärspule und die erste Sekundärspule induktiv gekoppelt sind; eine zweite Kopplungseinrichtung mit einer zweiten Primärspule und einer zweiten Sekundärspule, wobei die zweite Primärspule und die zweite Sekundärspule induktiv gekoppelt sind; bei der die erste und zweite Kopplungseinrichtung elektrisch miteinander verbunden sind und ein Übersetzungsverhältnis der Vorrichtung aus dem Produkt der Übersetzungsverhältnisse der ersten und zweiten Kopplungseinrichtungen gebildet ist.

Die Aufgabe wird auch gelöst durch ein Verfahren zum Messen von Wechselströmen, beinhaltend: Transformieren eines zu messenden Wechselstroms mittels eines ersten Transformators; Transformieren des transformierten Wechselstroms mittels eines zweiten, mit dem ersten Transformator elektrisch gekoppelten Transformators; wobei die jeweiligen Übersetzungsverhältnisse der ersten und zweiten Transformatoren so gewählt werden, dass ihr Produkt ein zum Messen erforderliches Übersetzungsverhältnis ergibt.

Nach einem Grundgedanken der vorliegenden Erfindung wird somit anstelle von aufwändigen und meist nur bedingt wirksamen Abschirm- und Signalentstörungsmaßnahmen ein zweistufiges Umwandeln des Messsignals durchgeführt. Dies ist gleichbedeutend damit, dass der erste Übertrager bzw. die erste Kopplungseinrichtung nicht mit einem niedrigen Widerstand (Shunt), sondern mit einem zweiten Übertrager abgeschlossen wird. Auf diese Weise kann jede gewünschte Gesamtübersetzung oder jedes gewünschte Übersetzungsverhältnis als Produkt zweier Übersetzungsverhältnisse realisiert werden, z.B. 1:25 als Produkt 1:5 x 1:5. Durch die jeweils gegenüber einem einzelnen Übertrager erniedrigte Windungszahl werden dabei störende Wicklungsresonanzen eliminiert. Zudem sind durch die erfindungsgemäße zweimalige galvanische Trennung Isolationsprobleme leichter lösbar. Darüber hinaus ist die kapazitive Kopplung von der ersten Primärleitung, d.h. der ersten Primärspule der ersten Kopplungseinrichtung auf die zweite Sekundärwicklung oder Sekundärspule praktisch gleich Null.

Gemäß einer besonderen Ausgestaltung der erfindungsgemäßen Vorrichtung ist zum Verbinden der ersten und zweiten Kopplungseinrichtungen die Primärspule der zweiten Kopplungseinrichtung mit der Sekundärspule der ersten Kopplungseinrichtung verbunden.

Des Weiteren kann durch die erfindungsgemäße zweistufige Ausbildung der Vorrichtung zwischen der ersten und der zweiten Kopplungseinrichtung ein endlicher Abstand, beispielsweise im Dezimeterbereich, bestehen, sodass der Abschlusswiderstand (Shunt) und die Signalleitung von diesem zu einem Messgerät oder einer Auswerteschaltung außerhalb des Einflussbereichs starker Hochfrequenzfelder liegt.

In Weiterbildung der erfindungsgemäßen Vorrichtung kann demnach vorgesehen sein, dass die zweite Kopplungseinrichtung zur Vermeidung der Einkopplung von Hochfrequenzfeldern in einem endlichen Abstand, d, zur ersten Kopplungseinrichtung angeordnet ist. Eine entsprechende Weiterbildung des erfindungsgemäßen Verfahrens sieht vor, dass der zweite Transformator derart beabstandet von dem ersten Transformator angeordnet wird, dass sich der zweite Transformator im Wesentlichen außerhalb der Reichweite elektromagnetischer Felder des ersten Transformators befindet.

Um dabei Messungenauigkeiten aufgrund der Länge einer entsprechenden nicht angepassten Leitung zwischen den ersten und zweiten Kopplungseinrichtungen zu vermeiden, kann in Weiterbildung der erfindungsgemäßen Vorrichtung vorgesehen sein, dass der Abstand, d, zwischen den ersten und zweiten Kopplungseinrichtungen weniger als 10% der Wellenlänge, λ, des zu messenden Wechselstroms beträgt, d.h. d < 0,1·λ.

Vorzugsweise ist in Weiterbildung der erfindungsgemäßen Vorrichtung die erste Primärspule durch eine Stromleitung gebildet, die den zu messenden Wechselstrom führt. Auf diese Weise ist die erste Primärspule mit einer Windungszahl Np1 = 1 ausgebildet.

Um möglichst niedrige Windungszahlen zu erreichen und somit störende Wicklungsresonanzen zu eliminieren, kann gemäß einer anderen Weiterbildung der erfindungsgemäßen Vorrichtung vorgesehen sein, dass die zweite Primärspule nur eine einzelne Windung aufweist.

Eine andere Weiterbildung der erfindungsgemäßen Vorrichtung sieht vor, dass die zweite Kopplungseinrichtung auf ihrer Sekundärseite ein elektrisches Widerstandsmittel zum niederohmigen Abschließen der zweiten Sekundärspule aufweist.

Für eine verbesserte Kopplung können im Zuge der Weiterbildung der erfindungsgemäßen Vorrichtung die erste Kopplungseinrichtung und/oder die zweite Kopplungseinrichtung jeweils einen Kern aus einem magnetisierbaren Material aufweisen, wobei dieser Kern jeweils als Ringkern ausgebildet sein kann.

Um die zweite Kopplungseinrichtung zur Vermeidung der Einkopplung von Hochfrequenzfeldern in einem endlichen Abstand, d, zur ersten Kopplungseinrichtung anzuordnen, dabei jedoch eine Beeinträchtigung der Signalübertragung zwischen der ersten Kopplungseinrichtung und der zweiten Kopplungseinrichtung zu vermeiden, sieht eine weitere Ausgestaltung der erfindungsgemäßen Vorrichtung vor, dass die erste und zweite Kopplungseinrichtung mittels einer verdrillten Doppelader (twisted pair) verbunden sind.

Das Übersetzungsverhältnis der erfindungsgemäßen Vorrichtung kann zwischen 1: 10 und 1:100 betragen. In jedem Fall jedoch sieht eine Weiterbildung der erfindungsgemäßen Vorrichtung zum Vermeiden von Wicklungsresonanzen vor, dass das Übersetzungsverhältnis der Vorrichtung im Wesentlichen gleichmäßig auf die ersten und zweiten Kopplungseinrichtungen aufgeteilt ist.

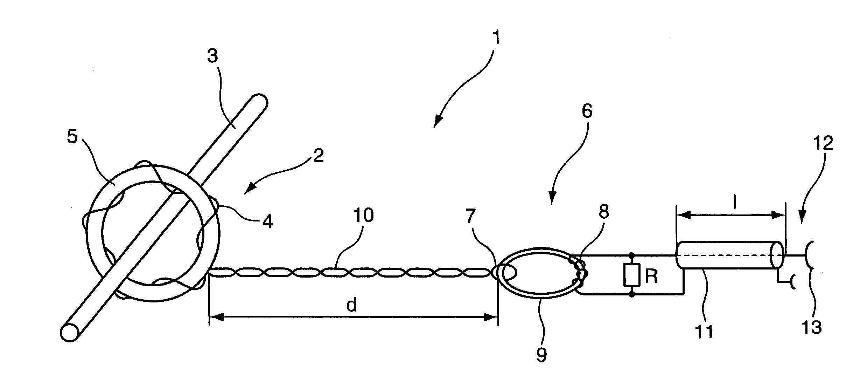

Weitere Merkmale und Vorteile der Erfindung ergeben sich aus der nachfolgenden Beschreibung von Ausführungsbeispielen der Erfindung, anhand der Zeichnung, welche erfindungswesentliche Einzelheiten zeigt, sowie aus den Ansprüchen. Die einzelnen Merkmale können je einzeln für sich oder zu mehreren in beliebiger Kombination bei einer Variante der Erfindung verwirklicht sein.

Bevorzugte Ausführungsbeispiele der Erfindung sind in der Zeichnung schematisch dargestellt und werden nachfolgend mit Bezug dazu näher erläutert. Die einzige Figur zeigt:
eine schematische Darstellung einer Ausgestaltung der erfindungsgemäßen Vorrichtung zum Messen von Wechselströmen.

Die Figur zeigt in schematischer Darstellung eine Vorrichtung zum Messen von insbesondere hochfrequenten Wechselströmen gemäß einer Ausgestaltung der vorliegenden Erfindung. Die erfindungsgemäße Vorrichtung 1 weist eine erste Kopplungseinrichtung 2 in Form eines Ringkopplers oder Ringkern-Transformators auf. Diese bzw. dieser umfasst eine erste Primärspule mit einer einzelnen Primärwindung, also Np1 = 1, die vorliegend durch einen Leiter 3 gebildet ist, der den zu messenden hochfrequenten Wechselstrom I_{HF} führt. Beispielsweise kann es sich bei dem Strom I_{HF} um einen Strom mit einer Frequenz von 13,56 MHz handeln. Weiterhin besitzt die Kopplungseinrichtung 2 eine erste Sekundärspule 4 mit beispielsweise Ns1 = 5 Windungen, die mit der Primärspule bzw. dem Leiter 3 über einen Ringkern 5 induktiv gekoppelt ist. Der Ringkern 5 besteht aus einem magnetisierbaren Material, z.B. einem Ferrit-Material, wie 4C6.

Zusätzlich zu der vorstehend beschriebenen ersten Kopplungseinrichtung 2 weist die erfindungsgemäße Vorrichtung noch eine zweite Kopplungseinrichtung 6 mit einer zweiten Primärspule 7 und einer zweiten Sekundärspule 8 auf. Die zweite Primärspule und die zweite Sekundärspule 8 sind ebenfalls über einen Ringkern 9 aus einem magnetisierbaren Material induktiv gekoppelt. Ebenso wie der Ringkern 5 kann auch der Ringkern 9 aus einem Ferrit-Material, wie 4C6, gebildet sein.

Bei der dargestellten Ausführungsform der erfindungsgemäßen Vorrichtung 1 weist die zweite Primärspule eine Windungszahl Np2= 1 und die zweite Sekundärspule 8 eine Windungszahl Ns2 = 4 auf. Die erste Sekundärspule 4 der ersten Kopplungseinrichtung 2 ist elektrisch leitend über eine verdrillte Doppelader 10 aus zwei verdrillten, isolierten Einzeldrähten mit der zweiten Primärspule 7 der zweiten Kopplungseinrichtung 6 verbunden. Dabei sind die erste Kopplungseinrichtung 2 und die zweite Kopplungseinrichtung 6 in einem endlichen Abstand d zueinander angeordnet.

Die zweite Sekundärspule 8 der zweiten Kopplungseinrichtung 6 ist mit einem kleinen Strommesswiderstand R niederohmig abgeschlossen, der auch als Bürde bezeichnet wird. Parallel zu dem Widerstand R ist ein Kabel 11 mit Länge 1 vorgesehen, vorliegend ein RG58-Koax-Antennenkabel mit einem Wellenwiderstand von 50 Ohm. Das Kabel 11 besitzt an seinem Ende 12 einen Stecker 13, beispielsweise einen BNC-Stecker zum Anschließen eines (nicht gezeigten) Messgeräts mit 75 oder 50 Ω-Eingang, wie eines Spannungsmessgeräts in Form eines Oszilloskops, oder einer geeigneten Auswerteschaltung.

Der Betrieb bzw. die Funktionsweise der vorstehend erläuterten erfindungsgemäßen Vorrichtung 1 zum Messen von Wechselströmen wird nachfolgend im Detail erläutert. Beispielsweise beträgt der zu messende Strom I_{HF} durch die Leitung 3 1 A. Dieser wird aufgrund des Windungsverhältnisses Np1:Ns1 = 1/5 der ersten Kopplungseinrichtung 2 (Ringkoppler) auf 200 mA heruntertransformiert. Der transformierte Strom wird dann über die Doppelader 10 zu der zweiten Kopplungseinrichtung 6 (Ringkoppler) geleitet, durchfließt dort die zweite Primärspule 7 und wird aufgrund des Windungsverhältnisses Np2:Ns2 = 1/4 auf 50 mA heruntertransformiert. Gemäß der Beziehung U = R·I fällt mit diesem Strom an einem Widerstand R = 3 Ohm (Shunt) am Eingang des Kabels 11 eine Spannung von 150 mV ab, die anschließend mit einem bei Bezugszeichen 13 angeschlossenen Messgerät (nicht gezeigt) zur Bestimmung des Stroms I_{HF} durch den Leiter 3 gemessen werden kann.

Erfindungsgemäß wird somit eine gewünschte Gesamtübersetzung von vorliegend beispielsweise 1:20 als Produkt zweier Übersetzungen 1:5 und 1:4 realisiert, wodurch durch die jeweils niedrige Windungszahl in den Kopplungseinrichtungen 2, 6 störende Wicklungsresonanzen eliminiert sind. Im Zuge möglicher Ausgestaltungen der vorliegenden Erfindung liegt das Gesamt-Übersetzungsverhältnis, d.h. das Produkt der Einzelübersetzungen vorzugsweise zwischen 1:10 und 1:100, wobei die Kopplungseinrichtungen 2, 6 zur Vermeidung von Wicklungsresonanzen vorteilhafter Weise insbesondere im Wesentlichen gleiche Übersetzungsverhältnisse aufweisen, sodass das Gesamt-Übersetzungsverhältnis der erfindungsgemäßen Vorrichtung entsprechend im Wesentlichen gleichmäßig auf die ersten und zweiten Kopplungseinrichtungen 2, 6 aufgeteilt ist. Mit anderen Worten: Für eine Gesamtübersetzung von 1:20 ist die Variante mit Einzel-Übersetzungsverhältnissen 1:4 und 1:5, d.h. mit im Wesentlichen gleichen Einzel-Übersetzungen einer Realisierung mit 1:2 und 1:10 vorzuziehen. Entsprechend ist bei einem gewünschten Gesamt-Übersetzungsverhältnis von beispielsweise 1:50 eine Realisierung mit Einzel-Übersetzungen 1:7 und 1:7 und einem Gesamt-Übersetzungsverhältnis von 1:49 einer Ausgestaltung mit Einzel-Übersetzungsverhältnissen 1:5 und 1:10 vorzuziehen. Aufgrund digitaler Signalaufbereitung kann die moderne Messtechik auch mit solchen Übersetzungsverhältnissen gut umgehen.

Zudem realisiert die erfindungsgemäße Vorrichtung eine doppelte galvanische Trennung, sodass sich Isolationsprobleme leichter lösen lassen. Weiterhin ist die kapazitive Kopplung von der ersten Primärleitung, d.h. dem Leiter 3 auf die zweite Sekundärspule oder Sekundärwicklung 8 praktisch Null, wodurch eine Verfälschung des Strommesssignals durch eine mögliche HF-Spannung des Leiters 3 entfällt.

Darüber hinaus lässt sich erfindungsgemäß durch entsprechende Anpassung einer Länge der Doppelader 10, d.h. des Abstands d zwischen der ersten Kopplungseinrichtung 2 und der zweiten Kopplungseinrichtung 6 erreichen, dass der Abschlusswiderstand R der zweiten Kopplungseinrichtung 6 bzw. der zweiten Sekundärspule 8, über dessen Spannungsabfall der Strom I_{HF} gemessen wird, und die Signalleitung von diesem zur Auswerteschaltung, d.h. das Kabel 11 nicht mehr im Bereich starker Hochfrequenzfelder liegen, welche durch den hochfrequenten Wechselstrom I_{HF} und die u.U. hohe Wechselspannung des Leiters 3 im Bereich der ersten Kopplungseinrichtung 2 erzeugt werden. Dabei sollen die ersten und zweiten Kopplungseinrichtungen 2, 6 möglichst weit voneinander entfernt liegen, um die vorstehend genannten Störeinflüsse zu vermeiden. Andererseits darf der Wert für d auch nicht beliebig groß gewählt werden, d.h. die Doppelader oder Leitung 10 darf nicht beliebig lang sein, da es sonst aufgrund der Leitungslänge zu Messungenauigkeiten käme, beispielsweise durch Reflexionen. Experimentell hat sich dabei eine Obergrenze d ≤ 0,1·λ herausgestellt, wobei λ die Wellenlänge der dem Wechselstrom I_{HF} zugeordneten elektromagnetischen Schwingung bezeichnet. Für das oben beschriebene Anwendungsbeispiel wurde experimentell ein optimaler Abstand d = 15 cm ermittelt.

Die Windungen der zweiten Primärspule 7 und der zweiten Sekundärspule 8 am Ringkern 9 der zweiten Kopplungseinrichtung 6 sind gemäß dem gezeigten Ausführungsbeispiel in maximalem Abstand relativ zueinander auf dem Kern angeordnet. Dadurch werden die Einflüsse eines Luftstreufeldes in der Umgebung des Ringkerns 9 minimiert. Werden die Spulen 7, 8 einander angenähert, d.h. auf dem Ringkern 9 verschoben, wird die zusätzliche Kopplung über Luftstreufelder größer. Auf diese Weise lässt sich durch relative Positionierung oder Anordnung der Windungen am Ringkern 9, d.h. in der zweiten Kopplungseinrichtung 6 das Strommesssignal exakt einstellen, so z.B. auf 100 mV/A im Falle des dargestellten Ausführungsbeispiels.

Im Rahmen von Ausgestaltungen der erfindungsgemäßen Vorrichtung kann diese insbesondere zum Messen von Strömen mit einer (effektiven) Stärke in einem Bereich von 1 bis 100 A bei Spannungen im Bereich von 100 bis einigen 1000 V eingesetzt werden. Dabei ist das Gesamt-Übersetzungsverhältnis der Vorrichtung vorzugsweise entsprechend derart gewählt, dass ein Potential am Ausgang der Sekundärwicklung der zweiten Kopplungseinrichtung auf dem Bezugspotential der restlichen Schaltung insbesondere nachfolgender Messgeräte und/oder Steuereinheiten liegt. Der zu messende Wechselstrom kann dabei insbesondere Frequenzen im Bereich von ca. 1 MHz bis ca. 60 MHz aufweisen.

Die Länge I des Kabels 11 (Koax-Antennenkabel RG58 mit Wellenwiderstand 50 Ohm) ist derart gewählt, dass die Signallaufzeit zum Messgerät für das Stromsignal und ein Spannungssignal, gemessen mit einer handelsüblichen 1:100-Sonde, gleich wird. So können z.B. mit einem Zweikanaloszilloskop Strom und Spannung des Leiters 3 phasenrichtig verglichen werden. Bei dem vorliegend beschriebenen Beispiel beträgt I = 123 cm.

Somit erfolgt erfindungsgemäß die Messung hochfrequenter Wechselströme zur Vermeidung aufwändiger und meist nur bedingt wirksamer Abschirm- und Signalentstörungsmaßnahmen zweistufig, indem zunächst der zu messende Wechselstrom mittels eines ersten Transformators umgewandelt wird, anschließend der transformierte Wechselstrom mittels eines zweiten Transformators weiter umgewandelt wird, wobei der zweite Transformator mit dem ersten Transformator verbunden ist und wobei die jeweiligen Übersetzungsverhältnisse der Transformatoren so gewählt werden, dass das Produkt der Übersetzungsverhältnisse das zum Messen des anfänglichen Wechselstroms erforderliche Übersetzungsverhältnis ergibt. Dabei wird der zweite Transformator erfindungsgemäß derart beabstandet von dem ersten Transformator angeordnet, dass sich der zweite Transformator im Wesentlichen außerhalb der Reichweite elektromagnetischer Hochfrequenzfelder des ersten Transformators bzw. des den zu messenden Strom führenden Leiters befindet.

## Patentansprüche

1. Vorrichtung (1) zum Messen von Wechselströmen (I_{HF}), aufweisend:
- eine erste Kopplungseinrichtung (2) mit einer ersten Primärspule (3) und einer ersten Sekundärspule (4), wobei die erste Primärspule und die erste Sekundärspule induktiv gekoppelt sind;
- eine zweite Kopplungseinrichtung (6) mit einer zweiten Primärspule (7) und einer zweiten Sekundärspule (8), wobei die zweite Primärspule und die zweite Sekundärspule induktiv gekoppelt sind;
bei der die erste und zweite Kopplungseinrichtung (2, 6) elektrisch miteinander verbunden sind und ein Übersetzungsverhältnis der Vorrichtung aus dem Produkt der Übersetzungsverhältnisse der ersten und zweiten Kopplungseinrichtungen gebildet ist.

2. Vorrichtung nach Anspruch 1, **dadurch gekennzeichnet, dass** die Primärspule (7) der zweiten Kopplungseinrichtung (6) mit der Sekundärspule (4) der ersten Kopplungseinrichtung (2) verbunden ist.

3. Vorrichtung nach Anspruch 1 oder 2, **dadurch gekennzeichnet, dass** die zweite Kopplungseinrichtung (6) zur Vermeidung der Einkopplung von Hochfrequenzfeldern in einem endlichen Abstand (d) zur ersten Kopplungseinrichtung (2) angeordnet ist.

4. Vorrichtung nach einem der Ansprüche 1 bis 3, **dadurch gekennzeichnet, dass** ein Abstand (d) zwischen den ersten und zweiten Kopplungseinrichtungen (2, 6) höchstens 10% der Wellenlänge (λ) eines zu messenden Wechselstroms (I_{HF}) beträgt.

5. Vorrichtung nach einem der Ansprüche 1 bis 4, **dadurch gekennzeichnet, dass** die erste Primärspule durch eine Stromleitung (3) gebildet ist, die einen zu messenden Wechselstrom (I_{HF}) führt.

6. Vorrichtung nach einem der Ansprüche 1 bis 5, **dadurch gekennzeichnet, dass** die zweite Primärspule (7) eine einzelne Windung aufweist.

7. Vorrichtung nach einem der Ansprüche 1 bis 6, **dadurch gekennzeichnet, dass** die zweite Kopplungseinrichtung (6) auf ihrer Sekundärseite ein elektrisches Widerstandsmittel (R) als niederohmigen Abschluss der zweiten Sekundärspule (8) aufweist.

8. Vorrichtung nach einem der Ansprüche 1 bis 7, **dadurch gekennzeichnet, dass** die erste Kopplungseinrichtung (2) einen Kern (5) aus einem magnetisierbaren Material aufweist.

9. Vorrichtung nach Anspruch 8, **dadurch gekennzeichnet, dass** der Kern (5) als Ringkern ausgebildet ist.

10. Vorrichtung nach einem der Ansprüche 1 bis 9, **dadurch gekennzeichnet, dass** die zweite Kopplungseinrichtung (6) einen Kern (9) aus einem magnetisierbaren Material aufweist.

11. Vorrichtung nach Anspruch 10, **dadurch gekennzeichnet, dass** der Kern (9) als Ringkern ausgebildet ist.

12. Vorrichtung nach einem der Ansprüche 1 bis 11, **dadurch gekennzeichnet, dass** die ersten und zweiten Kopplungseinrichtungen (2, 6) mittels einer verdrillten Doppelader (10) verbunden sind.

13. Vorrichtung nach einem der Ansprüche 1 bis 12, **dadurch gekennzeichnet, dass** die zweite Sekundärspule (8), insbesondere deren elektrisches Widerstandsmittel (R), mit einem Phasenanpassmittel (11) zum Anschließen eines Messgeräts verbunden ist, wobei das Phasenanpassmittel zum Angleichen einer Phase eines Wechselstromsignals und eines damit zu vergleichenden Wechselspannungssignals vorgesehen ist.

14. Vorrichtung nach einem der Ansprüche 1 bis 13, **dadurch gekennzeichnet, dass** die zweite Primärspule (7) und die zweite Sekundärspule (8) einstellbar relativ zueinander angeordnet sind.

15. Vorrichtung nach Anspruch 14, **dadurch gekennzeichnet, dass** über ein Einstellen der relative Anordnung ein Messsignalfeinabgleich vornehmbar ist.

16. Vorrichtung nach einem der Ansprüche 1 bis 15, **dadurch gekennzeichnet, dass** das Übersetzungsverhältnis der Vorrichtung zwischen 1:10 und 1:100 beträgt.

17. Vorrichtung nach einem der Ansprüche 1 bis 16, **dadurch gekennzeichnet, dass** das Übersetzungsverhältnis der Vorrichtung im Wesentlichen gleichmäßig auf die ersten und zweiten Kopplungseinrichtungen (2, 6) aufgeteilt ist.

18. Verfahren zum Messen von Wechselströmen (IHF) beinhaltend:
- Transformieren eines zu messenden Wechselstroms (I_{HF}) mittels eines ersten Transformators (2);
- Transformieren des transformierten Wechselstroms mittels eines zweiten, mit dem ersten Transformator elektrisch gekoppelten Transformators (6);
wobei die jeweiligen Übersetzungsverhältnisse der ersten und zweiten Transformatoren so gewählt werden, dass ihr Produkt ein zum Messen erforderliches Übersetzungsverhältnis ergibt.

19. Verfahren nach Anspruch 18, **dadurch gekennzeichnet, dass** der zweite Transformator (6) derart von dem ersten Transformator (2) beabstandet angeordnet wird, dass sich der zweite Transformator (6) im Wesentlichen außerhalb der Reichweite elektromagnetischer Hochfrequenzfelder des ersten Transformators (2) befindet.
